(19) Europäisches Patentamt / European Patent Office / Office européen des brevets

(11) **EP 2 670 048 B1**

(12) **FASCICULE DE BREVET EUROPEEN**

(45) Date de publication et mention
de la délivrance du brevet:
**04.03.2015 Bulletin 2015/10**

(51) Int Cl.:
*H03F 1/32* *(2006.01)* *H04B 1/04* *(2006.01)*

(21) Numéro de dépôt: **13169646.0**

(22) Date de dépôt: **29.05.2013**

(54) **Procédé de calibration de linéariseur et composant électronique linéarisé**

Eichverfahren eines Linearisierers, und linearisierte elektronische Komponente

Method for calibrating a lineariser and linearised electronic component

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.05.2012 FR 1254961**

(43) Date de publication de la demande:
**04.12.2013 Bulletin 2013/49**

(73) Titulaire: **Centre National d'Etudes Spatiales
75039 Paris Cedex 01 (FR)**

(72) Inventeurs:
 • **Sombrin, Jacques**
   **31400 Toulouse (FR)**
 • **Giraud, Xavier**
   **78000 Versailles (FR)**
 • **Guerin, Alexandre**
   **31000 Toulouse (FR)**
 • **Lesthievent, Guy**
   **31860 Villate (FR)**
 • **Millerioux, Jean-Pierre**
   **31400 Toulouse (FR)**
 • **Deplancq, Xavier**
   **31000 Toulouse (FR)**

(74) Mandataire: **Office Freylinger**
   **P.O. Box 48**
   **8001 Strassen (LU)**

(56) Documents cités:
   **EP-A1- 2 244 380       GB-A- 2 335 812
   JP-A- 2002 135 063     US-A1- 2006 240 786**

**Description**

**Domaine technique**

L'invention concerne, de manière générale, la compensation de distorsions non-linéaires. L'invention s'intéresse en particulier à la linéarisation par pré-distorsion, notamment à un procédé de calibration d'un linéariseur par pré-distorsion. Un autre aspect de l'invention concerne un dispositif mettant en oeuvre un tel procédé.

**Etat de la technique**

Les composants d'une chaîne de transmission analogique montrent tous un comportement non-linéaire plus ou moins important en fonction des particularités du signal transmis. Il est difficile, par exemple, de réaliser une chaîne de transmission à comportement linéaire sur une large bande passante et une grande plage de puissances du signal.

Des exemples typiques de sources de distorsion non-linéaire sont les convertisseurs numérique/analogique ou analogique/numérique et les amplificateurs, notamment les amplificateurs de puissance. Ces derniers fonctionnent en effet aussi près que possible de la saturation pour maximiser le rendement en puissance ajoutée. Or, le fait d'exploiter un amplificateur près de son point de saturation introduit des distorsions non-linéaires.

Pour un signal à modulation numérique, les effets les plus négatifs des non-linéarités sont l'augmentation du module du vecteur d'erreur (EVM, de l'anglais : « error vector magnitude ») et le rapprochement des points de la constellation. Pour augmenter l'efficacité spectrale, on est passé, dans le domaine des modulations à haute efficacité spectrale à des constellations de modulation par déplacement d'amplitude et de phase (APSK, de l'anglais : amplitude and phase shift keying) dont les plots sont plus espacés que les plots des constellations M-PSK (modulation par déplacement de phase à M états) mais qui sont plus sensibles aux effets des non-linéarités des amplificateurs de puissance.

La technique de compensation de non-linéarités d'un composant électronique par pré-distorsion est connue en tant que telle. Elle prévoit de placer un composant, appelé ci-après linéariseur par pré-distorsion, en amont du composant électronique dont la non-linéarité est à corriger. Le linéariseur par pré-distorsion applique une pré-distorsion au signal qui sera ensuite corrigée, au moins en partie, par les distorsions du composant électronique. Les paramètres de pré-distorsion sont choisis de manière à rendre l'ensemble (c.-à-d. le linéariseur par pré-distorsion et le composant électronique dont la non-linéarité est à corriger) aussi linéaire que possible.

Dans la suite, on fera la distinction entre le composant électronique (à linéariser) et l'ensemble comprenant le composant électronique et le linéariseur, qui sera appelé « composant électronique linéarisé ». Dans le cas d'un amplificateur (de puissance) à linéariser, l'ensemble linéariseur et amplificateur sera donc appelé « amplificateur (de puissance) linéarisé ».

L'avantage de placer le linéariseur en amont de l'amplificateur plutôt qu'en aval de celui-ci réside dans le fait que le rendement électrique de l'amplificateur se trouve moins dégradé.

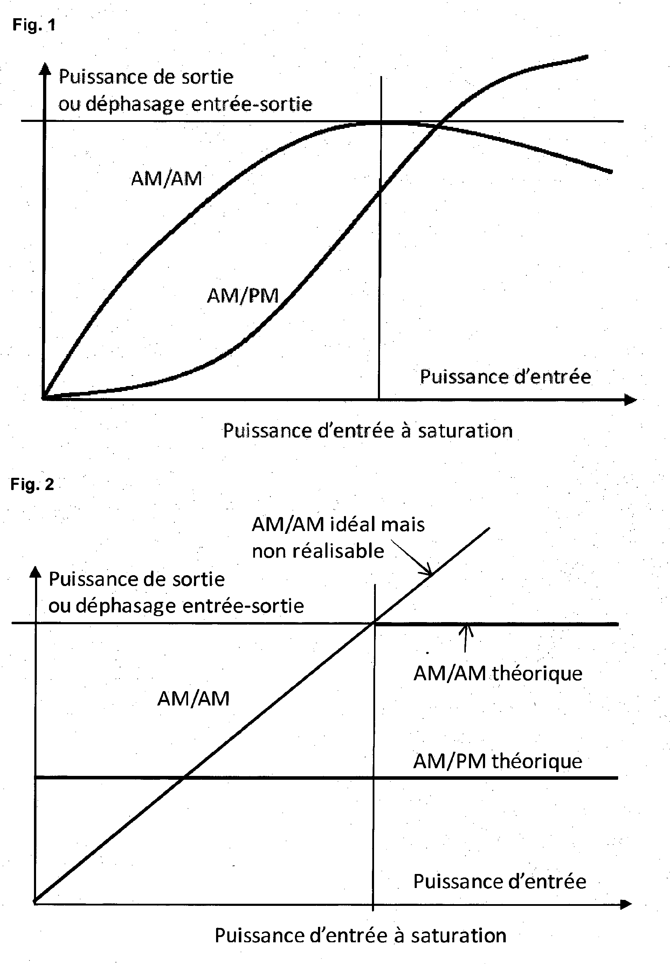

La figure 1 montre, de manière qualitative, la courbe de transfert en amplitude (courbe AM/AM représentant l'amplitude en sortie en fonction de l'amplitude en entrée) et la courbe de transfert en phase (courbe AM/PM représentant le déphasage du signal de sortie en fonction de l'amplitude en entrée) d'un amplificateur de puissance (sans effet de mémoire) à tube à onde progressive (ATOP). On note qu'un amplificateur à état solide ne présente pas de saturation. Ses courbes AM/AM et AM/PM seraient donc qualitativement différentes de celles montrées à la figure 1.

La figure 2 montre les courbes AM/AM et AM/PM d'un amplificateur idéal ou idéalement linéarisé. La courbe AM/AM est linéaire jusqu'à la saturation et plate au-delà, tandis que la fonction AM/PM est constante. On note qu'il n'est pas possible d'obtenir une courbe AM/AM linéaire allant au-delà de la puissance à saturation de l'amplificateur. On est amené à limiter la courbe AM/AM linéarisée à cette valeur de puissance maximale. On remarquera, par contre, que le gain linéarisé, c.-à-d. la pente de la courbe AM/AM, est, en principe, un paramètre libre. Il convient toutefois de garder un gain aussi grand que possible pour ne pas dégrader le rendement électrique. On essaie donc de conserver autant que possible le gain à saturation de l'amplificateur non linéaire.

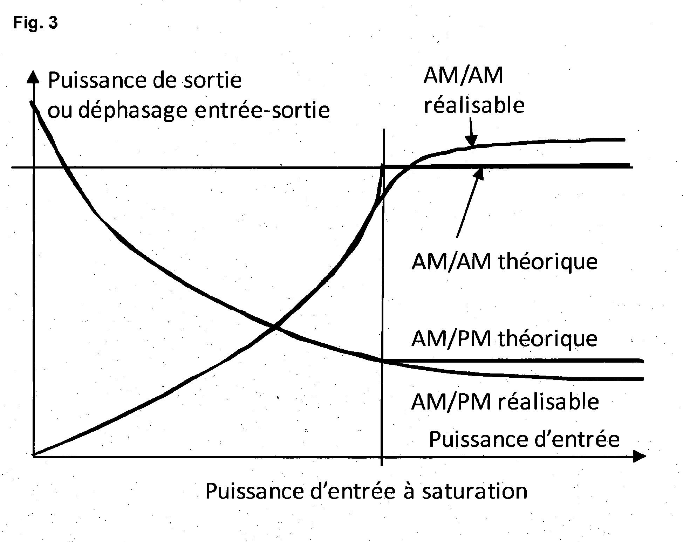

Le linéariseur par pré-distorsion a une courbe AM/AM inverse (au sens des fonctions mathématiques : $f^{-1}$) de la courbe AM/AM de l'amplificateur et une courbe AM/PM, en fonction de sa puissance de sortie, opposée à la courbe AM/PM de l'amplificateur. Les courbes AM/AM et AM/PM du linéariseur sont montrées de manière qualitative à la figure 3.

La linéarisation ne peut pas aller au-delà de la saturation de l'amplificateur (l'inverse de la courbe AM/AM n'existe plus). Le linéariseur est donc de préférence complété par un écrêteur ou un limiteur de puissance.

La courbe AM/AM théorique du linéariseur n'est pas réalisable physiquement de façon exacte jusqu'à la saturation. Une deuxième courbe AM/AM plus réaliste est donnée sur la figure 3. Il faut cependant s'approcher le mieux possible de la courbe AM/AM théorique à proximité de la saturation car les points de fonctionnement proches de la saturation sont ceux où le rendement électrique est le plus favorable. Ce point est moins difficile sur un amplificateur à état solide qui ne présente pas de seuil de saturation.

Le réglage du linéariseur peut être effectué :

∘ Une fois pour toutes en début d'exploitation de l'ensemble linéariseur-amplificateur. Cette variante présente le désavantage que des variations des conditions d'environnement et la dérive dans le temps des caractéristiques de l'amplificateur et du linéariseur peuvent dégrader la qualité de la linéarisation.

∘ Une fois pour toutes en début d'exploitation mais pour une gamme de paramètres comme la température, la fréquence, le gain, etc. afin d'obtenir un ensemble de courbes AM/AM et AM/PM, parmi lesquelles on choisit la mieux adaptée aux conditions d'environnement mesurées pendant l'exploitation de l'amplificateur linéarisé.

∘ Périodiquement, par une boucle de contre-réaction ou plusieurs, afin de suivre les variations supposées plus lentes de l'environnement et des caractéristiques des équipements.

∘ En permanence, par une boucle de contre-réaction ou plusieurs.

Toutes les méthodes de calibration de linéariseurs par pré-distorsion connues jusqu'ici mesurent directement le déphasage du signal de sortie par rapport à l'entrée, soit en utilisant un appareil de laboratoire (analyseur de réseau ou voltmètre vectoriel) en début d'exploitation, soit en démodulant le signal de sortie afin d'obtenir les voies I et Q (la phase est alors l'argument du nombre complexe I+jQ) ou bien l'amplitude et la phase du signal.

Ces méthodes de calibration par mesure de la phase nécessitent :

∘ de disposer d'un récepteur démodulateur qui peut être un appareil de mesure en laboratoire ou bien le récepteur de l'émetteur-récepteur dans le cas d'équipements de télécommunications bidirectionnels ;

∘ de définir des signaux de mesure particuliers ou bien d'utiliser les signaux, connus à l'avance, déjà présents dans le signal utile comme les pilotes de synchronisation ou les temps de montée et de descente;

∘ de définir une référence de temps et de phase entre les signaux d'entrée et de sortie et éventuellement de la calibrer elle-même par des signaux particuliers.

Le document WO 2004/040751 A1 décrit un linéariseur combinant plusieurs principes de linéarisation, à savoir la linéarisation par pré-distorsion, la linéarisation par correction en sortie (feed-forward) et la linéarisation par boucle de contre-réaction (feed-back). Un amplificateur linéarisé par pré-distorsion est inclus dans une boucle de correction en sortie, l'ensemble étant corrigé ou calibré par une boucle de contre-réaction.

La demande de brevet US 2007/0190952 A1 divulgue un mécanisme de calibration de linéariseur par pré-distorsion numérique. Le mécanisme utilise un récepteur intégré à la puce RF pour démoduler le signal RF amplifié en sortie de l'amplificateur. Les voies I et Q issues de la démodulation servent à calculer l'amplitude et la phase du signal amplifié. La linéarisation est effectuée dans un processeur en amont de la conversion numérique-analogique du signal à amplifier. L'amplitude du signal est fixée par un code qui active directement l'amplificateur, la phase est traitée par une voie différente et utilisée comme signal d'entrée de l'amplificateur.

La demande de brevet US 2009/0058521 A1 décrit un procédé de réduction de la distorsion non-linéaire d'un composant électronique par application d'un signal de stimulation à l'entrée du composant électronique et analyse des distorsions subies par le signal de stimulation. Un signal de correction est déterminé sur la base des distorsions constatées et ajouté au signal primaire en amont du composant électronique non-linéaire. Le signal de stimulation est un signal bi-fréquence, dont les composantes ont la même puissance. Plusieurs mesures de la distorsion sont réalisées dans un premier temps en maintenant un écart fixe entre les fréquences des deux composantes et en variant la fréquence centrale et dans un deuxième temps en maintenant fixe la fréquence centrale mais en variant l'écart entre les fréquences des deux composantes.

D'autres exemples de procédés de compensation de la distorsion non-linéaire par application d'un signal de test bi-fréquence peuvent être trouvés dans les documents de brevet EP 2 244 380, US 2006/240786, GB 2 335 812 et JP 2002/135063.

### Objet de l'invention

Un objectif de l'invention est de proposer un procédé de linéarisation par pré-distorsion permettant d'ajuster le réglage du linéariseur monté en amont d'un composant électronique à linéariser pendant l'exploitation de celui-ci pour prendre en compte les dérives des équipements ou en cas de changement de l'environnement, ceci sans nécessairement effectuer de mesure directe du déphasage du signal de sortie par rapport à l'entrée ou de démodulation du signal de sortie.

## Description générale de l'invention

Selon l'invention, un procédé de compensation de la distorsion non-linéaire d'un composant électronique (p.ex. un amplificateur, notamment un amplificateur de puissance, ou un convertisseur , etc.) destiné à produire un signal de sortie dépendant de manière linéaire d'un signal à transformer, comprend les étapes :

a) la transformation, dans le composant électronique, d'un signal à transformer ;

b) la pré-distorsion d'au moins une partie du signal à transformer en amont du composant électronique , la pré-distorsion étant réglée de sorte à compenser au moins partiellement une distorsion non-linéaire du composant électronique ; et

c) la détermination de paramètres de réglage de pré-distorsion ;

La détermination des paramètres de réglage de pré-distorsion comprend :

c1) l'application au composant électronique d'un signal de test bi-fréquence, comprenant une première composante de signal d'entrée à une première fréquence (notée $f_1$) et une seconde composante de signal d'entrée à une seconde fréquence (notée $f_2$), le niveau (de puissance) de la seconde composante de signal d'entrée étant inférieur au niveau (de puissance) de la première composante de signal d'entrée d'au moins 10 dB (de préférence d'au moins 15 dB et plus de préférence encore d'au moins 20 dB), de sorte à obtenir, en sortie du composant électronique, un signal de sortie comprenant une première composante de signal de sortie à la fréquence $f_1$, une seconde composante du signal de sortie à la fréquence $f_2$, ainsi qu'une troisième composante de signal de sortie à une troisième fréquence (notée $f_3$), symétrique de la fréquence $f_2$ par rapport à la fréquence $f_1$ (en d'autres termes : $f_3 = 2 f_1 - f_2$) ;

c2) la mesure du niveau (de puissance) relatif de la seconde composante du signal de sortie et du niveau (de puissance) relatif de la troisième composante du signal de sortie, ces niveaux relatifs étant mesurés par rapport au niveau de la première composante de signal de sortie ;

c3) le calcul d'une grandeur indicative de dissimilitude entre le spectre du signal de test bi-fréquence et le signal de sortie résultant de l'application du signal de test bi-fréquence au composant électronique, sur la base desdites mesures ;

c4) la pré-distorsion du signal de test en ajustant les paramètres de réglage de pré-distorsion de sorte à minimiser ladite dissimilitude ;

les paramètres de réglage de pré-distorsion ajustés étant appliqués lors de la pré-distorsion d'au moins une partie du signal à transformer.

Le niveau de la seconde composante de signal d'entrée n'est de préférence pas inférieur au niveau de la première composante de signal d'entrée de plus de 40 dB.

Les étapes c1) à c2) sont avantageusement réalisées pour une pluralité de niveaux de puissance du signal de test bi-fréquence, ce qui permet de réduire la dissimilitude des spectres d'entrée et de sortie sur une plage de puissances d'entrée allant p.ex. jusqu'à la puissance d'entrée à saturation ou à la puissance maximale d'utilisation du composant électronique. La grandeur indicative de dissimilitude peut alors être une fonction (entre autres) des niveaux de puissance relatifs des seconde et troisième composantes du signal de sortie.

De préférence, la grandeur indicative de dissimilitude entre le spectre du signal de test bi-fréquence et le signal de sortie résultant de l'application du signal de test bi-fréquence au composant électronique est une grandeur indicative du module du coefficient de conversion AM/PM (c.-à-d. la pente de la courbe AM/PM) du composant électronique. Dans ce cas, la pré-distorsion du signal de test est effectuée par ajustage des paramètres de réglage de pré-distorsion de sorte à minimiser le module du coefficient de conversion AM/PM. On notera que la minimisation du module du coefficient de conversion revient à rendre constante la fonction AM/PM du composant électronique linéarisé dans le voisinage d'une puissance d'entrée donnée. De préférence, les étapes c1) à c4) sont alors réalisées pour une pluralité de niveaux de puissance du signal de test bi-fréquence, ce qui permet de rendre constante la fonction AM/PM sur une plage de puissances en entrée s'étendant jusqu'à la puissance d'entrée à saturation ou à la puissance maximale d'utilisation du composant électronique. Connaissant le coefficient de conversion pour une population de puissances d'entrée suffisamment dense, on peut trouver la courbe AM/PM par intégration. Selon une réalisation préférée de l'invention, le signe du coefficient de conversion AM/PM du composant électronique est déterminé pour chaque niveau de puissance du signal de test bi-fréquence.

Il sera apprécié que le procédé proposé dans le cadre de cette invention ne comprenne pas de mesure directe de la phase sur le signal transformé (c.-à-d. le signal de sortie). Le procédé ne requiert donc pas de référence de temps ou de phase, difficile à réaliser hors laboratoire. L'invention trouvera un champ d'application particulièrement intéressant notamment sur des amplificateurs de puissance embarqués sur des satellites (de télécommunication ou autres). En effet, à cause des difficultés pour mettre en oeuvre une référence de temps et de phase et une chaîne calibrée de mesure de phase sur un satellite, il n'y a pas, à l'heure actuelle, de boucle de réglage de linéariseur d'amplificateur dans les satellites. Les linéariseurs utilisés dans le spatial sont actuellement calibrés une fois pour toutes sur la base de courbes AM/AM et AM/PM mesurées en laboratoire (à plusieurs fréquences centrales, si besoin est). Les paramètres de pré-distorsion calculés sont stockés dans une mémoire non-volatile (p.ex. un FPGA, de l'anglais « field programmable gate array ») du linéariseur. Les paramètres de pré-distorsion ne peuvent actuellement pas être corrigés en vol.

Grâce au procédé exposé ci-dessus, il est possible de déterminer la courbe AM/PM en effectuant uniquement des mesures spectrales, plus précisément, des mesures relatives d'amplitudes de raies dans le spectre de sortie du composant électronique.

Le procédé repose en partie sur une méthode de mesure décrite dans l'article: J. P. Laico, H. L. McDowell, and C. R. Moster, "A Medium Power Traveling-Wave Tube for 6000-Mc Radio Relay," Bell System Technical Journal, 3§(6), pp. 1285-1346, Nov. 1956, utilisée depuis pour des tests en orbite du satellite Symphonie en 1977 et en général pour des mesures d'ATOP ou de SSPA dans l'article: A. A. Moulthrop, C. J. Clark, C. F. Silva, and M. S. Muha, «A Dynamic AM/AM and AM/PM Measurement Technique», IEEE MTT-S Digest, 1997, pp. 1455-1458. A la connaissance des inventeurs, la méthode de mesure de distorsions décrite dans ces publications n'a encore jamais été utilisée dans le cadre d'un procédé de réglage d'un linéariseur.

Le procédé selon l'invention permet, par exemple, de faire un réglage (une recalibration) d'un linéariseur d'amplificateur sur un satellite en orbite pour corriger les conséquences du vieillissement, d'un changement de fréquence d'émission et/ou d'une modification des conditions d'environnement.

Les intervalles entre deux déterminations des paramètres de réglage de pré-distorsion peuvent être plus ou moins longs, selon les besoins de l'application. Des intervalles dans la plage de quelques secondes à plusieurs mois sont a priori possibles. Les intervalles peuvent être réguliers ou irréguliers. Il est également possible de n'effectuer de recalibrage qu'en cas de circonstances exceptionnelles. Comme le composant électronique linéarisé ne peut pas être exploité normalement lorsque des diagnostics sont exécutés, on essaiera de réduire le plus possible leur fréquence et leur durée.

Selon un mode d'exécution préféré de l'invention, la détermination de paramètres de réglage de pré-distorsion comprend en outre les étapes :

c5) l'application au composant électronique d'un signal de test mono-fréquence ;

c6) la mesure du niveau du signal obtenu à la fréquence du signal de test mono-fréquence en sortie du composant électronique lors de l'application du signal de test mono-fréquence ; et

c7) le calcul d'une grandeur indicative de la distorsion AM/AM (p.ex. la compression ou la pente de la courbe AM/AM) du composant électronique sur la base de ladite mesure.

L'ajustage des paramètres de réglage de pré-distorsion est alors effectué de sorte à minimiser non seulement la distorsion AM/PM mais aussi la distorsion AM/AM.

Les étapes c5) à c7) sont de préférence réalisées pour une pluralité de niveaux de puissance du signal de test mono-fréquence, ce qui permet de construire la courbe AM/AM du composant électronique linéarisé.

Au lieu des ou en complément aux étapes c5)-c7), une grandeur indicative de la distorsion AM/AM du composant électronique pourrait être calculée sur la base de la mesure du niveau relatif de la seconde composante du signal de sortie et de la mesure du niveau relatif de la troisième composante du signal de sortie. L'ajustage des paramètres de réglage de pré-distorsion qui est effectué de sorte à minimiser la distorsion AM/AM peut comprendre de régler la compression ou la pente de la courbe AM/AM sur une valeur prédéterminée, constante pour les différents niveaux du signal de test.

Le signal à transformer peut comprendre une porteuse modulée par un signal modulant. La pré-distorsion peut comprendre la pré-distorsion uniquement du signal modulant ou la pré-distorsion du signal entier. Dans le premier cas, le linéariseur par pré-distorsion est placé en amont du modulateur. Dans le deuxième cas, la porteuse modulée par le signal modulant est soumise à la pré-distorsion en aval du modulateur.

L'ajustage des paramètres de réglage de pré-distorsion peut comprendre le calcul d'une courbe AM/AM et d'une courbe AM/PM du composant électronique. En outre, l'ajustage des paramètres de réglage de pré-distorsion comprend de préférence le calcul de courbes AM/AM et AM/PM respectivement inverses des courbes AM/AM et AM/PM du composant électronique.

Le réglage du linéariseur est alors effectué de sorte à ce que sa courbe AM/AM soit l'inverse (au sens des fonctions mathématiques) de la courbe AM/AM du composant électronique et que sa courbe AM/PM, en fonction de sa puissance de sortie, soit opposée à la courbe AM/PM du composant électronique. Il convient de noter que les courbes AM/AM et AM/PM calculées du linéariseur par pré-distorsion peuvent être stockées sous forme de tableaux de correspondance (« look-up tables », LUTs, en anglais) dans une mémoire du linéariseur.

Un autre aspect de l'invention concerne un dispositif configuré de sorte à mettre en oeuvre le procédé décrit. Un tel dispositif, ci-après appelé composant électronique linéarisé comprend :

◦ un composant électronique, destiné à produire un signal de sortie dépendant de manière linéaire d'un signal à transformer ;

◦ un linéariseur par pré-distorsion pour la pré-distorsion d'au moins une partie du signal à transformer en amont du composant électronique, le linéariseur par pré-distorsion étant réglable de sorte à compenser au moins partiellement une distorsion non-linéaire du composant électronique ; et

◦ un dispositif de calibration configuré pour déterminer des paramètres de réglage de pré-distorsion et régler le linéariseur en conséquence.

Le dispositif de calibration est configuré pour mettre en oeuvre les étapes c1)-c4) et, optionnellement, les étapes c5)-c7) décrites ci-dessus. Le dispositif de calibration effectue en outre le réglage du linéariseur par application des paramètres de réglage de pré-distorsion au linéariseur pour la pré-distorsion d'au moins une partie du signal à transformer.

Encore un autre aspect de l'invention concerne un banc de test d'amplificateurs, comprenant un emplacement pour recevoir un amplificateur à tester ; un linéariseur par pré-distorsion disposé pour la pré-distorsion de signaux de test à appliquer à l'amplificateur à tester lorsque l'amplificateur à tester est placé dans son emplacement, le linéariseur par pré-distorsion étant réglable de sorte à compenser au moins partiellement une distorsion non-linéaire de l'amplificateur, et un dispositif de calibration configuré pour déterminer des paramètres de réglage de pré-distorsion et régler le linéariseur en conséquence et pour sortir des indicateurs de non-linéarité résiduelle. Le dispositif de calibration est configuré pour mettre en oeuvre les étapes c1)-c4) et, optionnellement, les étapes c5)-c7) décrites ci-dessus. Le dispositif de calibration effectue en outre le réglage du linéariseur par application des paramètres de réglage de pré-distorsion au linéariseur pour la pré-distorsion du signal de test.

En ce qui concerne les fréquences $f_1$ et $f_2$, elles sont de préférence choisies en fonction de caractéristiques spectrales du signal à transformer. Par exemple, on pourra choisir la fréquence $f_1$ égale à la fréquence porteuse du signal à transformer. La fréquence $f_2$ est choisie à l'intérieur de la bande passante du composant électronique de sorte à respecter un certain écart minimal entre $f_1$ et $f_2$, p.ex. : $\Delta f = |f_2-f_1| > 1$ MHz dans le cas d'un composant électronique ayant plusieurs MHz de bande passante, pour ne pas exciter des résonances dans le système d'alimentation. Si le composant électronique est un amplificateur à large bande (> environ 500 MHz), les courbes AM/AM et AM/PM peuvent présenter une variation significative en fonction de la fréquence. Avec une courbe AM/AM et une courbe AM/PM du linéariseur, on obtient une bonne linéarisation sur environ 500 MHz de bande. En cas de large bande de l'amplificateur, on peut donc exécuter le procédé selon l'invention pour une pluralité de paires de fréquences $f_1$ et $f_2$ judicieusement reparties dans la bande.

Brève description des dessins

D'autres particularités et caractéristiques de l'invention ressortiront de la description détaillée de quelques modes de réalisation avantageux présentés ci-dessous, à titre d'illustration, avec référence aux dessins annexés. Ceux-ci montrent:

Fig. 1 : une représentation qualitative des courbes AM/AM et AM/PM d'un ATOP ;

Fig. 2 : une représentation qualitative des courbes AM/AM et AM/PM d'un amplificateur idéal ou idéalement linéarisé ;

Fig. 3 : une représentation qualitative des courbes AM/AM et AM/PM d'un linéariseur par pré-distorsion ;

Fig. 4 : un schéma de principe d'une chaîne de transmission comprenant un dispositif amplificateur linéarisé selon un premier mode de réalisation préféré de l'invention ;

Fig. 5 : un schéma de principe d'une chaîne de transmission comprenant un dispositif amplificateur linéarisé selon un deuxième mode de réalisation préféré de l'invention ;

Fig. 6 : une représentation qualitative du spectre du signal bi-fréquence appliqué à l'entrée de l'amplificateur pour la détermination de sa courbe AM/PM ;

Fig. 7 : une représentation qualitative du spectre en sortie de l'amplificateur lorsque le signal bi-fréquence de la Fig. 6 est appliqué à l'entrée ;

Fig. 8 : un schéma de principe d'un banc de test pour amplificateurs utilisant le procédé selon l'invention.

Description d'une exécution préférée

Les figures 1 à 3 ont déjà été discutées dans l'introduction.

Linéarisation d'un amplificateur

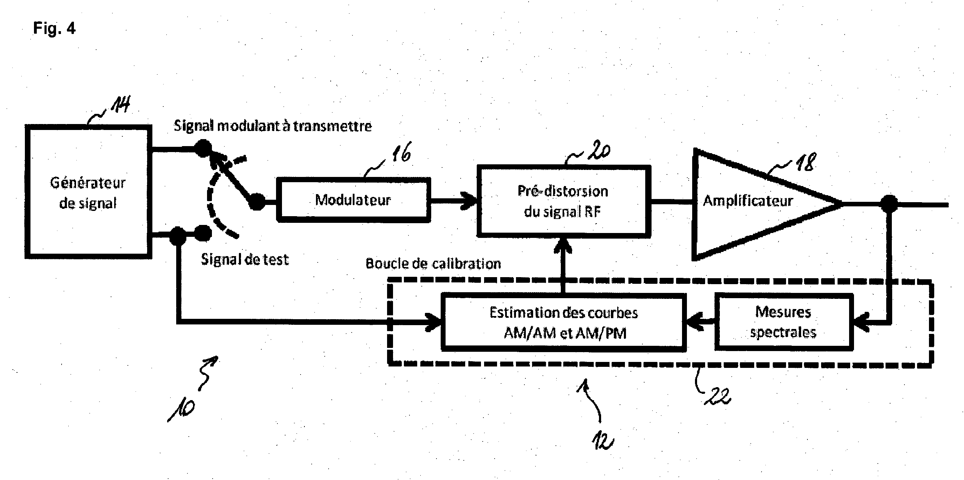

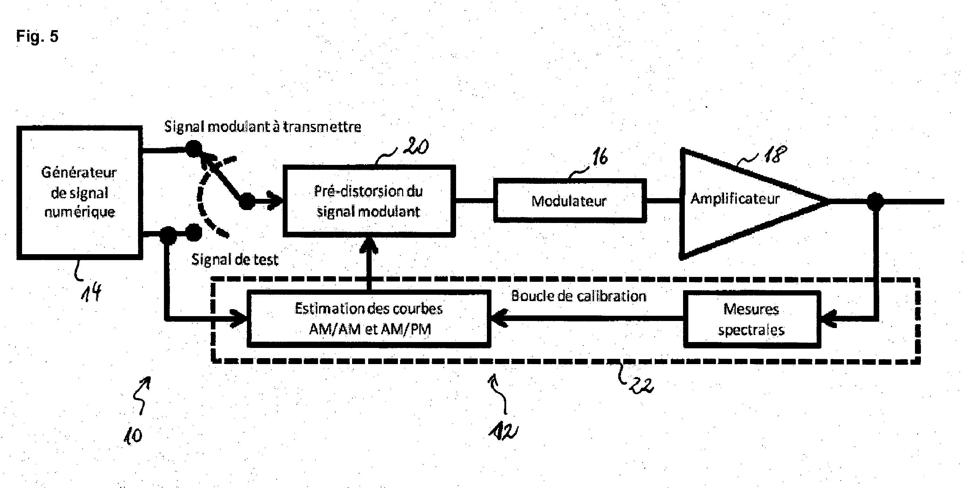

Une chaîne de transmission 10 comprenant un dispositif amplificateur linéarisé 12 selon un premier et un second modes de réalisation préférés de l'invention est montrée schématiquement sur la figure 4, respectivement sur la figure 5. La chaîne de transmission 10 comprend un générateur de signal 14 fournissant un signal en bande de base (signal modulant). Un modulateur 16 module le signal modulant sur une porteuse. Le signal RF obtenu est amplifié par un amplificateur de puissance 18. Un linéariseur par pré-distorsion 20 est disposé en amont de l'amplificateur 18 de sorte à compenser, au moins en partie, les distorsions non-linéaires apportées au signal par l'amplificateur 18. Selon le mode de réalisation de l'invention illustré sur la figure 4, le linéariseur par pré-distorsion 20 est placé en aval du modulateur 16 et agit donc sur le signal RF à amplifier. Sur la figure 5, le linéariseur par pré-distorsion 20 est placé en amont du modulateur 16 et agit uniquement sur le signal modulant. Dans le mode de réalisation selon la figure 4, on peut utiliser un linéariseur RF conventionnel. Dans le mode de réalisation selon la figure 5, on peut utiliser un linéariseur par pré-distorsion numérique, plus flexible. Les linéariseurs numériques actuels ont toutefois le désavantage d'une bande passante plus étroite.

La chaîne de transmission comprend un dispositif de calibration 22 qui gouverne le linéariseur par pré-distorsion 20. Le dispositif de calibration 22 est réalisé comme une boucle qui mesure les distorsions non-linéaires de signaux de test et détermine, sur la base de ces mesures, les paramètres de réglage de la pré-distorsion effectuée par le linéariseur 20.

Pour la détermination des paramètres de réglage de pré-distorsion, le générateur génère des signaux de test. Pendant que ce procédé de diagnostic est exécuté, la transmission du signal modulant est interrompue.

Le réglage du linéariseur par pré-distorsion peut être effectué de différentes manières expliquées plus en détail dans la suite.

1) Réglage par inversion des courbes AM/AM et AM/PM

Selon une première méthode possible, on déduit des mesures les courbes AM/AM et AM/PM de l'amplificateur linéarisé et on calcule la pré-distorsion nécessaire pour rapprocher ces courbes au mieux des courbes idéales (voir figure 2).

Le dispositif de calibration est configuré pour déterminer les courbes AM/AM et AM/PM sans avoir recours à des mesures directes de la phase du signal amplifié.

La détermination de la courbe AM/AM comprend l'application d'un signal de test mono-fréquence (ayant un spectre à raie unique de préférence à la fréquence de porteuse). Le dispositif de calibration 22 mesure l'amplitude de cette raie en sortie de l'amplificateur 18 en faisant varier la puissance du signal de test mono-fréquence en entrée. La courbe AM/AM de l'amplificateur de puissance linéarisé (c.-à-d. le linéariseur 20 suivi de l'amplificateur 18) s'obtient en calculant le rapport de l'amplitude de la raie en sortie à l'amplitude de la raie en entrée pour une pluralité de puissances en entrée.

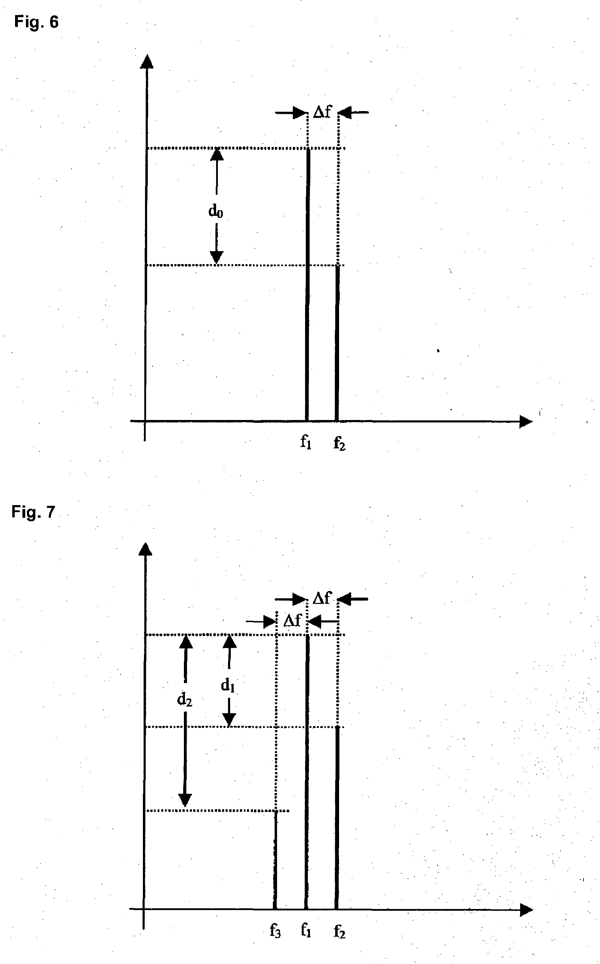

La détermination de la courbe AM/PM est indirecte. On utilise une méthode connue de l'article de Laico et autres (référence complète en haut). Dans ce cas, on applique un signal de test bi-fréquence. Le signal de test bi-fréquence comprend une première composante de signal d'entrée à la fréquence $f_1$ et une seconde composante de signal d'entrée à la fréquence $f_2$. Le spectre correspondant est illustré sur la figure 6. Le niveau de raie à la fréquence $f_2$ est nettement inférieur au niveau de la raie à la fréquence $f_1$ : $d_0 > 10$ dB, de préférence $d_0 > 15$ dB voire $> 20$ dB.

Le dispositif de calibration mesure les amplitudes relatives des raies dans le spectre du signal de test amplifié, illustré sur la figure 7. A cause des non-linéarités, une troisième raie apparaît dans le spectre du signal amplifié à une fréquence $f_3$, symétrique de la fréquence $f_2$ par rapport à la fréquence $f_1$ ($f_3 = 2 f_1 - f_2$). Le dispositif de calibration mesure les niveaux des raies aux fréquences $f_2$ et $f_3$ par rapport au niveau de la raie centrale.

On note $d_1$ le rapport entre le niveau de la raie à la fréquence $f_2$ et le niveau de la raie centrale et $d_2$ le rapport entre le niveau de la raie à la fréquence $f_3$ et le niveau de la raie centrale. On suppose que $d_1$ et $d_2$ (ainsi que $d_0$) sont exprimés en dB. Le module du coefficient de conversion (c.-à-d. le module de la pente de la courbe AM/PM) peut alors être calculé par la formule suivante :

$$|K_p| = \frac{2}{0{,}152}\sqrt{S_1^2 - \left(\frac{1 + S_1^2 - S_2^2}{2}\right)^2} \, , \qquad \text{(Eq. 1)}$$

où Kp désigne le coefficient de conversion en °/dB (la pente du déphasage en degrés par dB), et où

$$S_1^{\;2} = 10^{(d_0 - d_1)/10} \text{ et } S_2^{\;2} = 10^{(d_0 - d_2)/10}.$$

La déduction de cette formule est expliquée dans l'article de Laico et autres. $|K_p|$ est déterminé pour différentes puissances du signal de test à l'entrée (en gardant le rapport $d_0$ constant).

On note ici que la compression (AM/AM), notée c, peut également être calculée grâce aux valeurs $S_1$ et $S_2$ :

$$c = 1 - (S_1^{\;2} - S_2^{\;2}) \, . \qquad \text{(Eq. 2)}$$

Il est donc possible de calculer la pente de la courbe AM/AM, notée $K_a$, et de déduire la courbe AM/AM en utilisant les mesures $d_0$, $d_1$ et $d_2$ faites lors de l'application du signal de test bi-fréquence. Pour la détermination de la courbe AM/AM il n'est donc pas nécessaire de passer par la méthode qui comprend l'application d'un signal de test mono-fréquence décrite plus haut.

La courbe AM/PM s'obtient par intégration de $K_p$ à une constante additive près (qui peut être fixée de manière arbitraire). Il faut donc lever le doute sur le signe de $K_p$ pour chaque valeur de la puissance d'entrée du signal de test. On note que le signe de $K_p$ est connu et fixe pour les amplificateurs à tube à onde progressive mais ce n'est pas le cas pour tous les types d'amplificateurs. Par exemple, le signe de Kp d'un SSPA (amplificateur de puissance à état solide, de l'anglais « solid-state power amplifier ») n'est pas constant sur toute la courbe AM/PM. (En d'autres termes, la courbe AM/PM d'un SSPA n'est pas monotone.) Il en est de même pour un ATOP linéarisé ; dans ce cas, $K_p$ peut changer de signe plusieurs fois, mais $|K_p|$ reste faible (p.ex. inférieur à 1 °/dB).

Une façon simple de lever le doute sur le signe de Kp est de lui ajouter une valeur d'amplitude et de signe connus, par exemple en faisant agir le dispositif de calibration sur le linéariseur de sorte à modifier la courbe de correction AM/PM du linéariseur par pré-distorsion) et de mesurer le nouveau module du coefficient Kp obtenu. Connaissant la valeur initiale $|K_p|$, la valeur $|K_p'|$ obtenue après modification de la courbe de correction AM/PM et le signe de Kp-Kp', on peut accéder à Kp (et à Kp'). On peut éventuellement améliorer la précision avec une troisième mesure en inversant le signe de la quantité connue que l'on ajoute.

Une autre méthode plus globale consiste à calculer une courbe de correction AM/PM en assumant une valeur Kp positive pour chaque puissance d'entrée du signal de test et d'appliquer la correction obtenue. Ensuite on vérifie si on a une amélioration ($|K_p|$ proche de 0°/dB) avec cette correction pour toutes les puissances d'entrée du signal de test. Aux puissances d'entrée du signal de test où on constate une dégradation ($|K_p|$ augmente), on inverse le signe. Au lieu d'assumer toutes les valeurs de Kp positives, on peut naturellement aussi commencer avec l'assomption contraire.

De préférence, les valeurs des modules de Kp mesurées sont comparées avec l'erreur de mesure, car il est inutile de chercher le signe d'un coefficient Kp (ou d'un résidu de coefficient Kp après correction) si le module est inférieur à l'erreur de mesure. Une précision importante doit être obtenue sur les amplitudes des raies si on veut mesurer des coefficients Kp de module inférieur à 1°/dB. On constate en effect qu'une erreur de mesure de 0,2 dB donne une erreur de Kp de 0,1 à 0,6 °/dB suivant Kp et la compression. Si Kp est inférieur à 1°/dB, certaines combinaisons d'erreur peuvent faire apparaître un nombre négatif sous le radical de l'éq. 1. Si, pour éviter cette situation pendant l'exécution de la calibration, on forçait ce nombre à sa valeur absolue, on ferait une erreur plus importante sur les petites valeurs de $K_p$. En comparant $|K_p|$ à l'erreur de mesure, on peut vérifier rapidement si des courbes de correction déterminées auparavant sont toujours adéquates ou bien s'il faut refaire une calibration complète. Si on réalise le test avec les courbes de correction précédentes et si on trouve une correction différentielle nulle ou inférieure à l'erreur de mesure, il est inutile de changer la correction.

Grâce à l'invention, on a les possibilités de faire varier la puissance de sortie de l'ATOP ainsi que la compensation du gain par l'amplificateur de canal en sortie du linéariseur. La calibration permet alors d'obtenir les courbes AM/AM et AM/PM adaptées à cette puissance de fonctionnement, dans l'environnement réel et en tenant compte du vieillissement de l'amplificateur.

<u>2) Réglage en boucle d'erreur</u>

Lorsque le réglage du linéariseur par pré-distorsion est à peu près correct, la boucle de calibration peut fonctionner en comparant les courbes AM/AM et AM/PM de l'amplificateur linéarisé aux courbes AM/AM linéaire et AM/PM idéales. On peut alors calculer une erreur quadratique par exemple en sommant les carrés des erreurs en chaque point de mesure. Une modification des paramètres de réglage du linéariseur par pré-distorsion donne des erreurs différentes. On peut alors obtenir une mesure du gradient de l'erreur en fonction des paramètres de réglage. Ce gradient peut ensuite être utilisé pour affiner le réglage ou pour suivre les évolutions de l'environnement ou le vieillissement de l'amplificateur. Dans ce mode de fonctionnement, le dispositif de calibration fonctionne en boucle d'erreur. Une inversion (au sens des fonctions mathématiques) des courbes AM/AM et AM/PM de l'amplificateur, du linéariseur ou de l'ensemble des deux n'est pas nécessaire pendant ce mode de fonctionnement.

Par exemple, les mesures de $|K_p|$ et de $K_a$ (pente de la courbe AM/AM en dB/dB) pour M+N mesures en fonction du niveau d'entrée (dont N en-dessous de la saturation et M au-delà de la saturation) peuvent être utilisées pour calculer une erreur quadratique :

$$err^2 = \alpha\left[\frac{1}{M+N}\sum_{i=1}^{M+N}K_{p,i}^{\ 2}\right] + \beta\left[\frac{1}{N}\sum_{i=1}^{N}(K_{a,i}-1)^2\right] + \gamma\left[\frac{1}{M}\sum_{i=N+1}^{M+N}K_{a,i}^{\ 2}\right], \qquad \text{(Eq. 3)}$$

où err$^2$ désigne l'erreur quadratique et les parameters $\alpha$, $\beta$ et y doivent être adaptés suivant l'importance que l'on donne à la phase et au module du gain dynamique, en dessous et au dessus de la saturation. Des erreurs de 1°/dB sur Kp et 0,1 dB/dB sur $K_a$ ont le même ordre d'importance. Ces ordres de grandeur sont donc à vérifier, p.ex. par des simulations.

La formule de l'erreur quadratique ci-dessus ne fait intervenir que le carré du module de conversion $K_p$. Il n'est donc pas nécessaire de lever le doute sur son signe. Par contre, il est recommandé de remplacer $K_{p,i}^{\ 2}$ par 0 ou par son module si le carré est négatif afin de ne pas perturber le calcul de l'erreur quadratique par des termes négatifs.

On vérifie que l'erreur est nulle si la pente de la courbe AM/AM est constante (c.-à-d. $K_a$ = constant) de 0 à la saturation et nulle au-delà et si la pente de la courbe AM/PM est nulle partout (Kp=0).

Une modification des paramètres de réglage du linéariseur par pré-distorsion donne une erreur quadratique différente. On peut alors obtenir une mesure du gradient de l'erreur quadratique en fonction des paramètres de réglage du linéariseur même si on ne connait pas l'action de chaque réglage sur les courbes AM/AM et AM/PM du linéariseur.

Ce mode de fonctionnement permet d'utiliser n'importe quel linéariseur réglable, y compris les linéariseurs analogiques large bande, disponibles aujourd'hui mais dont chaque réglage agit à la fois sur la courbe AM/AM et sur la courbe AM/PM, ceci sans qu'il soit nécessaire de modéliser ce fonctionnement complexe.

Le gradient obtenu lors de mesures successives peut être utilisé pour affiner le réglage ou pour suivre les évolutions de l'environnement ou le vieillissement de l'amplificateur.

Des algorithmes de suivi de gradient sont bien connus et leurs seul inconvénient est la possibilité de rester bloqué dans un minimum local. Ceci est susceptible d'arriver surtout lorsque le nombre de paramètres à optimiser est important. De nombreuses solutions pourtant ont été publiées pour éviter ce problème.

Le mode de fonctionnement en boucle d'erreur est aussi utilisable pour un linéariseur numérique plus simple à modéliser car il permet d'éviter la mesure directe de la courbe de phase ou l'intégration à partir de la mesure de Kp avec lever de doute sur le signe ainsi que l'inversion des courbes AM/AM et AM/PM. Le nombre de paramètres de réglage doit rester acceptable pour l'optimiseur utilisé, par exemple en se donnant des modèles des courbes AM/AM et AM/PM ou des courbes inverses.

Une autre possibilité de fonctionnement en boucle d'erreur est de raisonner uniquement sur les mesures des niveaux relatifs des deuxième et troisième composantes du signal de sortie de l'amplificateur obtenu par application du signal de test bi-fréquence. La boucle d'erreur essaie dans ce cas de minimiser une grandeur indicative de la dissimilitude des spectres d'entrée et de sortie (au moins jusqu'à la saturation) qui ne dépend pas (directement) de $K_p$ et/ou de $K_a$.

En-dessous de la saturation, (pour N mesures), on exige que le niveau relatif de la première porteuse soit identique au niveau relatif à l'entrée et que la puissance de la porteuse symétrique soit nulle. Au-delà de la saturation, (pour M mesures), on veut conserver uniquement la modulation de phase du signal d'entrée, soit deux porteuses de même amplitude et de niveau relatif p.ex. 6 dB plus bas que celui de la porteuse d'entrée. On peut alors poser comme fonction d'erreur quadratique :

$$err^2 = \alpha\left[\frac{1}{N}\sum_{i=1}^{N}(d_1 - d_0)^2\right] + \beta\left[\frac{1}{N}\sum_{i=1}^{N}d_2^2\right] + \gamma\left[\frac{1}{M}\sum_{i=N+1}^{M+N}(d_1 - \frac{d_0}{4})^2\right] + \delta\left[\frac{1}{M}\sum_{i=N+1}^{M+N}(d_2 - \frac{d_0}{4})^2\right]$$

(Eq. 4)

Cette formule ne faisant pas apparaître les coefficients $K_a$ ni $K_p$, le calcul est toujours possible. Par contre, la formule ne permet pas d'affecter un poids défini à la linéarisation de la courbe AM/AM et à la linéarisation de la courbe AM/PM.

Il faut noter aussi qu'au-delà de la saturation, cette formule ne peut garantir que la modulation est uniquement une modulation de phase du signal d'entrée ; il pourrait en effet y avoir une combinaison de modulations de phase et d'amplitude si la non linéarité a une mémoire. Mais il en est de même pour la méthode reposant sur $K_a$ et $K_p$.

Exemples d'applications

Le procédé de calibration présenté dans le cadre de ce document peut être utilisé pour linéariser un amplificateur spatial (à bord d'un satellite en orbite), p.ex. un ATOP, ou sur un banc de test. D'autres applications sont évidemment possibles. L'avantage principal de la méthode est qu'une mesure directe de la phase, en utilisant une référence de temps et de phase, n'est pas requise.

Actuellement, les performances des ATOP sont mesurées sans linéariseur (chez le fabricant de tubes puis l'intégrateur du tube et de son alimentation). Ensuite le client, réalise un amplificateur linéarisé. Les performances de linéarité du tube seul ne sont pas représentatives de celles que l'on pourra obtenir après linéarisation.

On peut cependant envisager de mesurer un ATOP « linéarisé au mieux » par un linéariseur donné, réglé au mieux en fonction de la mesure des courbes de l'ATOP.

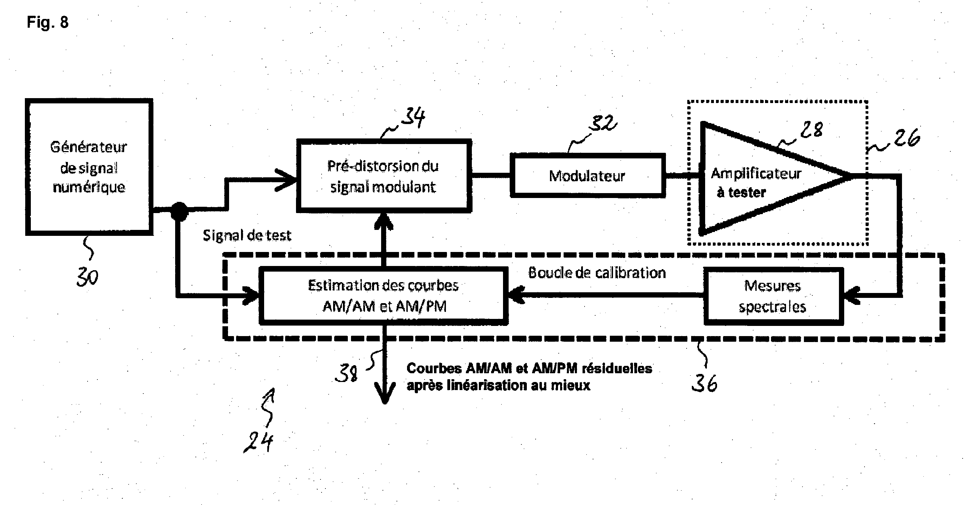

Le procédé selon l'invention permet de réaliser un banc de test qui n'a pas besoin d'une référence de temps et de phase mais qui mesure les non-linéarités du dispositif testé et les corrige de manière automatique. Les non-linéarités résiduelles (après application de la meilleure pré-distorsion trouvée) pourront être utilisées pour spécifier les performances de linéarité du dispositif testé « linéarisé au mieux ». Un tel banc de test est montré sur la figure 8.

Le banc de test 24 montré sur la figure 8 est analogue au dispositif amplificateur linéarisé montré sur la figure 5. Le banc de test 24 comprend un emplacement 26 pour recevoir un amplificateur à tester 28. Un générateur de signaux de test 30 fournit un signal de test en bande de base. Un modulateur 32 module le signal de test sur une porteuse. Le signal RF obtenu est appliqué à l'amplificateur à tester 28 placé dans l'emplacement prévu à cet effet. Un linéariseur par pré-distorsion 34 est disposé en amont de l'amplificateur à tester 28 de sorte à compenser les distorsions non-linéaires apportées au signal RF par l'amplificateur à tester 28. Le dispositif de calibration 36 qui gouverne le linéariseur par pré-distorsion 34 est réalisé comme une boucle qui mesure les distorsions non-linéaires de signaux de test et détermine, sur la base de ces mesures, les paramètres de réglage de la pré-distorsion effectuée par le linéariseur. Le dispositif de calibration 36 comprend en outre une sortie 38 sur laquelle il met à disposition des indicateurs de non-linéarité résiduelle, p.ex. les courbes AM/AM et AM/PM de l'amplificateur à tester 28 après linéarisation « au mieux ».

Il reste à noter que le banc de test 24 pourrait également être configuré analogue au dispositif amplificateur linéarisé montré sur la figure 4. La question de savoir quelle configuration doit être préférée peut dépendre du type d'amplificateurs à tester et de leur utilisation visée.

Choix de l'amplitude de seconde composante du signal de test bi-fréquence

Le signal de test bi-fréquence (Fig. 6) comprend une première composante de signal d'entrée à une première fréquence et une seconde composante de signal d'entrée à une seconde fréquence, le niveau de la seconde composante de signal d'entrée étant nettement inférieur au niveau de la première composante de signal d'entrée.

Une amplitude trop élevée de la deuxième composante par rapport à la première composante revient à mesurer une moyenne du coefficient $K_a$ ou $K_p$ sur une gamme importante de niveaux. En effet, la deuxième composante peut être interprétée, en partie, comme une modulation d'amplitude de la première composante d'autant plus importante que son niveau est élevé.

On a les correspondances suivantes entre le niveau relatif des deux composante du signal de test bi-fréquence et la modulation d'amplitude crête-à-crête de la première composante :

| Niveau relatif (dB) | Amplitude relative de la modulation | Modulation d'amplitude crête-à-crête (dB) |
|---|---|---|
| 10 | 0,32 | 5,69 |
| 15 | 0,18 | 3,12 |
| 20 | 0,10 | 1,74 |
| 30 | 0,03 | 0,55 |

Une différence de niveaux de 10 dB est utilisable mais donne accès à la mesure d'une pente moyenne entre deux points situés à plus ou moins 3 dB du niveau moyen auquel on fait la mesure. Une différence de niveaux de 15 dB moyenne sur plus ou moins 1,5 dB. Des différences de niveaux de 20 à 30 dB sont préférées.

Des erreurs de mesure de l'ordre de 0,1 à 0,5 dB sur les niveaux relatifs sont acceptables en général mais peuvent conduire à des erreurs importantes sur des coefficients Kp inférieurs à 0,5 °/dB, y compris l'impossibilité de faire le calcul selon la formule pour le module de Kp (Eq. 1) dans le cas où le nombre dont on prend la racine carrée devient négatif. Pour stabiliser le calcul, on peut prendre la valeur absolue de ce nombre ou, ce qui est préférable, prendre 0 s'il est négatif. Ceci entraîne une erreur sur les valeurs faibles de Kp (valeurs inférieures à 0,5 °/dB). Cette erreur dépend de la valeur de Kp et de la compression. Toutefois, l'erreur moyenne reste de l'ordre de 0,5°/dB.

Comme la deuxième composante a besoin d'avoir une amplitude suffisante pour minimiser les erreurs sur les mesures de puissance relative, il est recommandé de ne pas réduire le niveau de la seconde composante du signal de test à plus de 40 dB en dessous de la première composante du signal de test.

**Légende:**

| | |
|---|---|
| 10 | Chaîne de transmission |
| 12 | Dispositif amplificateur linéarisé |
| 14 | Générateur de signal |
| 16 | Modulateur |
| 18 | Amplificateur |
| 20 | Linéariseur par pré-distorsion |
| 22 | Dispositif de calibration |
| 24 | Banc de test |
| 26 | Emplacement pour un amplificateur à tester |
| 28 | Amplificateur à tester |
| 30 | Générateur de signaux de test |
| 32 | Modulateur |
| 34 | Linéariseur par pré-distorsion |
| 36 | Dispositif de calibration |
| 38 | Sortie |

**Revendications**

1. Procédé de compensation de la distorsion non-linéaire d'un composant électronique (18, 28) destiné à produire un signal de sortie dépendant de manière linéaire d'un signal à transformer, comprenant :

   a) la transformation, dans le composant électronique (18, 28), du signal à transformer ;
   b) la pré-distorsion (20, 34) d'au moins une partie du signal d'entrée en amont du composant électronique (18, 28), la pré-distorsion étant réglée de sorte à compenser au moins partiellement une distorsion non-linéaire du composant électronique (18, 28) ; et
   c) la détermination de paramètres de réglage de pré-distorsion ;

   le procédé étant **caractérisé en ce que** la détermination de paramètres de réglage de pré-distorsion comprend

   c1) l'application au composant électronique (18, 28) d'un signal de test bi-fréquence (Fig. 6), comprenant une première composante de signal d'entrée à une première fréquence et une seconde composante de signal d'entrée à une seconde fréquence, le niveau de la seconde composante de signal d'entrée étant inférieur au niveau de la première composante de signal d'entrée d'au moins 10 dB, de sorte à obtenir, en sortie du composant électronique (18, 28), un signal de sortie (Fig. 7) comprenant une première composante de signal de sortie à ladite première fréquence, une seconde composante du signal de sortie à ladite seconde fréquence ainsi qu'une troisième composante de signal de sortie à une troisième fréquence, symétrique de la seconde fréquence par rapport à la première fréquence ;

c2) la mesure du niveau relatif de la seconde composante du signal de sortie et du niveau relatif de la troisième composante du signal de sortie, ces niveaux relatifs étant mesurés par rapport au niveau de la première composante de signal de sortie ;

c3) le calcul d'une grandeur indicative de dissimilitude entre le spectre du signal de test bi-fréquence et le signal de sortie résultant de l'application du signal de test bi-fréquence au composant électronique (18, 28), sur la base desdites mesures;

c4) la pré-distorsion du signal de test en ajustant les paramètres de réglage de pré-distorsion de sorte à minimiser ladite dissimilitude ;

les paramètres de réglage de pré-distorsion ajustés étant appliqués lors de ladite pré-distorsion d'au moins une partie du signal à transformer.

2. Procédé selon la revendication 1, dans lequel ladite grandeur indicative de dissimilitude est une grandeur indicative du module du coefficient de conversion AM/PM du composant électronique (18, 28) et dans lequel ladite dissimilitude est minimisée par la minimisation du module du coefficient de conversion AM/PM.

3. Procédé selon la revendication 2, dans lequel la détermination de paramètres de réglage de pré-distorsion comprend

c5) l'application au composant électronique (18, 28) d'un signal de test mono-fréquence,

c6) la mesure du niveau du signal obtenu à la fréquence du signal de test mono-fréquence en sortie du composant électronique lors de l'application du signal de test mono-fréquence ;

c7) le calcul d'une grandeur indicative de la distorsion AM/AM de du composant électronique sur la base de ladite mesure ;

l'ajustage des paramètres de réglage de pré-distorsion étant en outre effectué de sorte à minimiser la distorsion AM/AM.

4. Procédé selon la revendication 2, dans lequel la détermination de paramètres de réglage de pré-distorsion comprend le calcul d'une grandeur indicative de la distorsion AM/AM du composant électronique sur la base de la mesure du niveau relatif de la seconde composante du signal de sortie et de la mesure du niveau relatif de la troisième composante du signal de sortie ;

et dans lequel l'ajustage des paramètres de réglage de pré-distorsion est en outre effectué de sorte à minimiser la distorsion AM/AM.

5. Procédé selon l'une quelconque des revendications 1 à 4, dans lequel ledit signal à transformer comprend une porteuse modulée par un signal modulant et dans lequel la pré-distorsion d'au moins une partie du signal à transformer comprend la pré-distorsion du signal modulant.

6. Procédé selon l'une quelconque des revendications 1 à 4, dans lequel ledit signal à transformer comprend une porteuse modulée par un signal modulant et dans lequel la porteuse modulée par le signal modulant est soumise à ladite pré-distorsion.

7. Procédé selon l'une quelconque des revendications 1 à 6, dans lequel les étapes c1) à c4) sont réalisées pour une pluralité de niveaux de puissance du signal de test bi-fréquence.

8. Procédé selon la revendication 7 si dépendante de la revendication 2, dans lequel le signe du coefficient de conversion AM/PM du composant électronique (18, 28) est déterminé pour chaque niveau de puissance du signal de test bi-fréquence.

9. Procédé selon la revendication 3 ou l'une quelconque des revendications 4 à 8 si dépendante de la revendication 3, dans lequel les étapes c5) à c7) sont réalisées pour une pluralité de niveaux de puissance du signal de test mono-fréquence.

**10.** Procédé selon les revendications 8 et 9, dans lequel l'ajustage des paramètres de réglage de pré-distorsion comprend le calcul d'une courbe AM/AM et d'une courbe AM/PM du composant électronique (18, 28) et, optionnellement, le calcul de courbes AM/AM et AM/PM respectivement inverses des courbes AM/AM et AM/PM du composant électronique (18, 28).

**11.** Procédé selon l'une quelconque des revendications 1 à 10, dans lequel ledit composant électronique est un amplificateur, p.ex. un amplificateur de puissance, et dans lequel ledit signal à transformer est un signal à amplifier.

**12.** Composant électronique linéarisé (12), comprenant :

un composant électronique (18), destiné à produire un signal de sortie dépendant de manière linéaire d'un signal à transformer, ledit composant électronique étant de préférence un amplificateur, p.ex. un amplificateur de puissance, ledit signal à transformer étant dans ce cas un signal à amplifier ;
un linéariseur par pré-distorsion (20) pour la pré-distorsion d'au moins une partie du signal à transformer en amont du composant électronique (18), le linéariseur par pré-distorsion (20) étant réglable de sorte à compenser au moins partiellement une distorsion non-linéaire du composant électronique ; et
un dispositif de calibration (22) configuré pour déterminer des paramètres de réglage de pré-distorsion et régler le linéariseur (20) en conséquence ;
le composant électronique linéarisé (12) étant **caractérisé en ce que** le dispositif de calibration (22) est configuré pour mettre en oeuvre :

l'application au composant électronique (18) d'un signal de test bi-fréquence (Fig. 6), comprenant une première composante de signal d'entrée à une première fréquence et une seconde composante de signal d'entrée à une seconde fréquence, le niveau de la seconde composante de signal d'entrée étant inférieur au niveau de la première composante de signal d'entrée d'au moins 10 dB, de sorte à obtenir, en sortie du composant électronique (18), un signal de sortie (Fig. 7) comprenant une première composante de signal de sortie à ladite première fréquence, une seconde composante du signal de sortie à ladite seconde fréquence ainsi qu'une troisième composante de signal de sortie à une troisième fréquence, symétrique de la seconde fréquence par rapport à la première fréquence ;
la mesure du niveau de la seconde composante du signal de sortie et du niveau de la troisième composante du signal de sortie ;
le calcul d'une grandeur indicative du module du coefficient de conversion AM/PM du composant électronique (18) sur la base desdites mesures ;
la pré-distorsion du signal de test en ajustant les paramètres de réglage de pré-distorsion de sorte à minimiser le module du coefficient de conversion AM/PM ; et
le réglage du linéariseur (20) par application des paramètres de réglage de pré-distorsion au linéariseur (20) pour la pré-distorsion d'au moins une partie du signal à transformer.

**13.** Composant électronique linéarisé (12) selon la revendication 12, dans lequel le dispositif de calibration (22) est configuré pour mettre en oeuvre :

l'application au composant électronique (18) d'un signal de test mono-fréquence,
la mesure du niveau du signal obtenu à la fréquence du signal de test mono-fréquence en sortie du composant électronique (18) lors de l'application du signal de test mono-fréquence ;
le calcul d'une grandeur indicative de la distorsion AM/AM du composant électronique (18) sur la base de ladite mesure ; et
l'ajustage des paramètres de réglage de pré-distorsion de sorte à minimiser la distorsion AM/AM.

**14.** Banc de test d'amplificateurs (24), comprenant
un emplacement (26) pour recevoir un amplificateur à tester (28) ;
un linéariseur par pré-distorsion (34) disposé pour la pré-distorsion de signaux de test à appliquer à l'amplificateur (28) à tester lorsque l'amplificateur à tester est placé dans ledit emplacement (26), le linéariseur par pré-distorsion (34) étant réglable de sorte à compenser au moins partiellement une distorsion non-linéaire de l'amplificateur (28) ; et
un dispositif de calibration (36) configuré pour déterminer des paramètres de réglage de pré-distorsion et régler le linéariseur (34) en conséquence et comprenant une sortie (38) pour sortir des indicateurs de non-linéarité résiduelle ;
le dispositif de calibration (36) étant configuré pour mettre en oeuvre :

l'application à l'amplificateur à tester (28) d'un signal de test bi-fréquence (Fig. 6), comprenant une première composante de signal d'entrée à une première fréquence et une seconde composante de signal d'entrée à une seconde fréquence, le niveau de la seconde composante de signal d'entrée étant inférieur au niveau de la première composante de signal d'entrée d'au moins 10 dB, de sorte à obtenir, en sortie de l'amplificateur à tester (28), un signal de sortie (Fig. 7) comprenant une première composante de signal de sortie à ladite première fréquence, une seconde composante du signal de

sortie à ladite seconde fréquence ainsi qu'une troisième composante de signal de sortie à une troisième fréquence, symétrique de la seconde fréquence par rapport à la première fréquence ;

la mesure du niveau de la seconde composante du signal de sortie et du niveau de la troisième composante du signal de sortie ;

le calcul d'une grandeur indicative du module du coefficient de conversion AM/PM de l'amplificateur à tester (28) sur la base desdites mesures ; la pré-distorsion du signal de test en ajustant les paramètres de réglage de pré-distorsion de sorte à minimiser le module du coefficient de conversion AM/PM; et

le réglage du linéariseur (34) par application des paramètres de réglage de pré-distorsion au linéariseur (34) pour la pré-distorsion du signal de test bi-fréquence.

**15.** Banc de test (24) selon la revendication 14, dans lequel le dispositif de calibration (36) est configuré pour mettre en oeuvre :

l'application à l'amplificateur à tester (28) d'un signal de test mono-fréquence,
la mesure du niveau du signal obtenu à la fréquence du signal de test mono-fréquence en sortie de l'amplificateur à tester (28) lors de l'application du signal de test mono-fréquence ;
le calcul d'une grandeur indicative de la distorsion AM/AM de l'amplificateur à tester (28) sur la base de ladite mesure ; et
l'ajustage des paramètres de réglage de pré-distorsion de sorte à minimiser la distorsion AM/AM.

## Patentansprüche

**1.** Verfahren zur Kompensation der nichtlinearen Verzerrung eines elektronischen Bauteils (18, 28) zum Erzeugen eines von einem umzuwandelnden Signal linear abhängigen Ausgangssignals, umfassend die Schritte:

a) Umwandeln des umzuwandelnden Signals im elektronischen Bauteil (18, 28);
b) Vorverzerren (20, 34) wenigstens eines Teils des Eingangssignals vor dem elektronischen Bauteil (18, 28), wobei die Vorverzerrung so regelbar ist, dass eine nichtlineare Verzerrung des elektronischen Bauteils (18, 28) wenigstens zum Teil kompensiert wird; und
c) Ermitteln der Regelparameter für die Vorverzerrung;

wobei das Verfahren **dadurch gekennzeichnet ist, dass** die Ermittlung der Regelparameter für die Vorverzerrung folgende Schritte umfasst:

c1) Anlegen eines Dualfrequenz-Testsignals an das elektronische Bauteil (18, 28) (Fig. 6), welches Signal eine erste Eingangssignalkomponente mit einer ersten Frequenz und eine zweite Eingangssignalkomponente mit einer zweiten Frequenz aufweist, wobei der Pegel der zweiten Eingangssignalkomponente um mindestens 10 dB unter dem Pegel der ersten Eingangssignalkomponente liegt, so dass am Ausgang des elektronischen Bauteils (18, 28) ein Ausgangssignal erhalten wird (Fig. 7), welches eine erste Ausgangssignalkomponente mit der ersten Frequenz, eine zweite Ausgangssignalkomponente mit der zweiten Frequenz sowie eine dritte Ausgangssignalkomponente mit einer dritten Frequenz aufweist, die bezogen auf die erste Frequenz zur zweiten Frequenz symmetrisch ist;
c2) Messen des relativen Pegels der zweiten Ausgangssignalkomponente und des relativen Pegels der dritten Ausgangssignalkomponente, wobei diese relativen Pegel in Bezug auf die erste Ausgangssignalkomponente gemessen werden;
c3) Berechnen einer Richtgröße für die Unähnlichkeit zwischen dem Spektrum des Dualfrequenz-Testsignals und dem aus dem Anlegen des Dualfrequenz-Testsignals an das elektronische Bauteil (18, 28) resultierenden Ausgangssignal auf der Grundlage dieser Messungen;
c4) Vorverzerren des Testsignals, indem die Regelparameter für die Vorverzerrung so eingestellt werden, dass die Ungleichheit minimiert wird;

wobei die eingestellten Regelparameter für die Vorverzerrung bei der Vorverzerrung wenigstens eines Teils des umzuwandelnden Signals angewendet werden.

2. Verfahren nach Anspruch 1, wobei die Richtgröße für die Ungleichheit eine Richtgröße für das AM/PM-Umwandlungskoeffizientenmodul des elektronischen Bauteils (18,28) ist und wobei die Unähnlichkeit durch Minimierung des AM/PM-Umwandlungskoeffizientenmoduls minimiert wird.

3. Verfahren nach Anspruch 2, wobei die Ermittlung der Regelparameter für die Vorverzerrung folgende Schritte umfasst:

 c5) Anlegen eines Monofrequenz-Testsignals an das elektronische Bauteil (18, 28);
 c6) Messen des mit der Frequenz des Monofrequenz-Testsignals am Ausgang des elektronischen Bauteils beim Anlegen des Monofrequenz-Testsignals erhaltenen Signalpegels;
 c7) Ermitteln einer Richtgröße für die AM/AM-Verzerrung des elektronischen Bauteils auf der Grundlage dieser Messung;

wobei die Einstellung der Regelparameter für die Vorverzerrung zudem so durchgeführt wird, dass die AM/AM-Verzerrung minimiert wird.

4. Verfahren nach Anspruch 2, wobei die Einstellung der Regelparameter für die Vorverzerrung die Berechnung einer Richtgröße für die AM/AM-Verzerrung des elektronischen Bauteils auf der Grundlage der Messung des relativen Pegels der zweiten Ausgangssignalkomponente und der Messung des relativen Pegels der dritten Ausgangssignalkomponente umfasst;
und wobei die Einstellung der Regelparameter für die Vorverzerrung zudem so durchgeführt wird, dass die AM/AM-Verzerrung minimiert wird.

5. Verfahren nach irgendeinem der Ansprüche 1 bis 4, wobei das umzuwandelnde Signal eine mit einem modulierenden Signal modulierte Trägerwelle enthält und wobei die Vorverzerrung wenigstens eines Teils des umzuwandelnden Signals die Vorverzerrung des modulierenden Signals umfasst.

6. Verfahren nach irgendeinem der Ansprüche 1 bis 4, wobei das umzuwandelnde Signal eine mit einem modulierenden Signal modulierte Trägerwelle enthält und wobei die mit dem modulierenden Signal modulierte Trägerwelle der Vorverzerrung unterzogen wird.

7. Verfahren nach irgendeinem der Ansprüche 1 bis 6, wobei die Schritte c1) bis c4) für eine Vielzahl von Leistungspegeln des Dualfrequenz-Testsignals durchgeführt werden.

8. Verfahren nach Anspruch 7 falls abhängig von Anspruch 2, wobei das Vorzeichen des AM/PM-Umwandlungskoeffizienten des elektronischen Bauteils (18, 28) für jeden Leistungspegel des Dualfrequenz-Testsignals bestimmt wird.

9. Verfahren nach Anspruch 3 oder irgendeinem der Ansprüche 4 bis 8 falls abhängig von Anspruch 3, wobei die Schritte c5) bis c7) für eine Vielzahl von Leistungspegeln des Dualfrequenz-Testsignals durchgeführt werden.

10. Verfahren nach den Ansprüchen 8 und 9, wobei die Einstellung der Regelparameter für die Vorverzerrung die Berechnung einer AM/AM-Kurve und einer AM/PM-Kurve des elektronischen Bauteils (18, 28) sowie optional die Berechnung von zu diesen AM/AM- und AM/PM-Kurven des elektronischen Bauteils (18, 28) jeweils inversen AM/AM- und AM/PM-Kurven umfasst.

11. Verfahren nach irgendeinem der Ansprüche 1 bis 10, wobei das elektronische Bauteil ein Verstärker ist, zum Beispiel ein Leistungsverstärker, und wobei das umzuwandelnde Signal ein zu verstärkendes Signal ist.

12. Linearisiertes elektronisches Bauteil (12), umfassend:

 ein elektronisches Bauteil (18) zum Erzeugen eines von einem umzuwandelnden Signal linear abhängigen Ausgangssignals, wobei das elektronische Bauteil vorzugsweise ein Verstärker, zum Beispiel ein Leistungsverstärker, und das umzuwandelnde Signal in diesem Fall ein zu verstärkendes Signal ist;
 einen Linearisierer mit Vorverzerrung (20) für die Vorverzerrung wenigstens eines Teils des umzuwandelnden Signals vor dem elektronischen Bauteil (18), wobei der Linearisierer mit Vorverzerrung (20) so einstellbar ist, dass eine nichtlineare Verzerrung des elektronischen Bauteils wenigstens zum Teil kompensiert wird; und eine Kalibriervorrichtung (22), die dazu eingerichtet ist, die Regelparameter für die Vorverzerrung zu ermitteln und den Linearisierer (20) entsprechend einzustellen;

wobei das linearisierte elektronische Bauteil (12) **dadurch gekennzeichnet ist, dass** die Kalibriervorrichtung (22) für die Durchführung folgender Schritte eingerichtet ist:

Anlegen eines Dualfrequenz-Testsignals an das elektronische Bauteil (18) (Fig. 6), welches Signal eine erste Eingangssignalkomponente mit einer ersten Frequenz und eine zweite Eingangssignalkomponente mit einer zweiten Frequenz aufweist, wobei der Pegel der zweiten Eingangssignalkomponente um mindestens 10 dB unter dem der ersten Eingangssignalkomponente liegt, so dass am Ausgang des elektronischen Bauteils (18) ein Ausgangssignal erhalten wird (Fig. 7), welches eine erste Ausgangssignalkomponente mit der ersten Frequenz, eine zweite Ausgangssignalkomponente mit der zweiten Frequenz sowie eine dritte Ausgangssignalkomponente mit einer dritten Frequenz aufweist, die bezogen auf die erste Frequenz zur zweiten Frequenz symmetrisch ist;
Messen des Pegels der zweiten Ausgangssignalkomponente und des Pegels der dritten Ausgangssignalkomponente:,
Berechnen einer Richtgröße für das AM/PM-Umwandlungskoeffizientenmodul des elektronischen Bauteils (18) auf der Grundlage dieser Messungen;
Vorverzerren des Testsignals, indem die Regelparameter für die Vorverzerrung so eingestellt werden, dass das AM/PM-Umwandlungskoeffizientenmodul minimiert wird; und
Einstellen des Linearisierers (20), indem die Regelparameter für die Vorverzerrung auf den Linearisierer (20) zur Vorverzerrung wenigstens eines Teils des umzuwandelnden Signals angewendet werden.

13. Linearisiertes elektronisches Bauteil (12) nach Anspruch 12, wobei die Kalibriervorrichtung (22) für die Durchführung folgender Schritte eingerichtet ist:

Anlegen eines Monofrequenz-Testsignals an das elektronische Bauteil (18);
Messen des mit der Frequenz des Monofrequenz-Testsignals am Ausgang des elektronischen Bauteils (18) beim Anlegen des Monofrequenz-Testsignals erhaltenen Signalpegels;
Berechnen einer Richtgröße für die AM/AM-Verzerrung des elektronischen Bauteils (18) auf der Grundlage dieser Messung; und
Einstellen der Regelparameter für die Vorverzerrung, so dass die AM/AM-Verzerrung minimiert wird.

14. Prüfstand (24) für Verstärker, aufweisend
einen Aufnahmeplatz (26) zur Aufnahme eines zu prüfenden Verstärkers (28);
einen Linearisierer mit Vorverzerrung (34), der für die Vorverzerrung von Testsignalen zum Anlegen an den zu prüfenden Verstärker (28) eingerichtet ist, wenn sich der zu prüfende Verstärker in dem Aufnahmeplatz (26) befindet, wobei der Linearisierer mit Vorverzerrung (20) so einstellbar ist, dass eine nichtlineare Verzerrung des Verstärkers (28) wenigstens zum Teil kompensiert wird; und
eine Kalibriervorrichtung (36), die dazu eingerichtet ist, die Regelparameter für die Vorverzerrung zu ermitteln und den Linearisierer (34) entsprechend einzustellen, und die einen Ausgang (38) zur Ausgabe von Indikatoren für verbleibende Nichtlinearität aufweist;
wobei die Kalibriervorrichtung (36) für die Durchführung folgender Schritte eingerichtet ist:
Anlegen eines Dualfrequenz-Testsignals an den zu prüfenden Verstärker (28) (Fig. 6), welches Signal eine erste Eingangssignalkomponente mit einer ersten Frequenz und eine zweite Eingangssignalkomponente mit einer zweiten Frequenz aufweist, wobei der Pegel der zweiten Eingangssignalkomponente um mindestens 10 dB unter dem der ersten Eingangssignalkomponente liegt, so dass am Ausgang des zu prüfenden Verstärkers (28) ein Ausgangssignal erhalten wird (Fig. 7), welches eine erste Ausgangssignalkomponente mit der ersten Frequenz, eine zweite Ausgangssignalkomponente mit der zweiten Frequenz sowie eine dritte Ausgangssignalkomponente mit einer dritten Frequenz aufweist, die bezogen auf die erste Frequenz zur zweiten Frequenz symmetrisch ist;
Messen des Pegels der zweiten Ausgangssignalkomponente und des Pegels der dritten Ausgangssignalkomponente;
Berechnen einer Richtgröße für das AM/PM-Umwandlungskoeffizientenmodul des zu prüfenden Verstärkers (28) auf der Grundlage dieser Messungen;
Vorverzerren des Testsignals, indem die Regelparameter für die Vorverzerrung so eingestellt werden, dass das AM/PM-Umwandlungskoeffizientenmodul minimiert wird; und
Einstellen des Linearisierers (34), indem die Regelparameter für die Vorverzerrung auf den Linearisierer (34) zur Vorverzerrung des Dualfrequenz-Testsignals angewendet werden.

15. Prüfstand (24) nach Anspruch 14, wobei die Kalibriervorrichtung (36) für die Durchführung folgender Schritte eingerichtet ist:

Anlegen eines Monofrequenz-Testsignals an den zu prüfenden Verstärker (28);
Messen des mit der Frequenz des Monofrequenz-Testsignals am Ausgang des zu prüfenden Verstärkers (28) beim Anlegen des Monofrequenz-Testsignals erhaltenen Signalpegels;
Berechnen einer Richtgröße für die AM/AM-Verzerrung des zu prüfenden Verstärkers (28) auf der Grundlage dieser Messung; und
Einstellen der Regelparameter für die Vorverzerrung, so dass die AM/AM-Verzerrung minimiert wird.

**Claims**

1. A method for compensating the nonlinear distortion of an electronic component (18, 28) intended to produce an output signal linearly dependent on a signal to be converted, comprising

a) converting, in the electronic component (18, 28), the signal to be converted;
b) predistorting (20, 34) at least part of the input signal upstream of the electronic component (18, 28), said being set so as at least in part to compensate a nonlinear distortion of the electronic component (18, 28); and
c) determining predistortion setting parameters;

the method being **characterized in that** the determination of predistortion setting parameters comprises:

c1) applying a bifrequency test signal (Fig. 6) to the electronic component (18, 28), said test signal comprising a first input signal component at a first frequency and a second input signal component at a second frequency, the level of the second input signal component being at least 10 dB lower than the level of the first input signal component, so as to obtain, at the output of the electronic component (18, 28), an output signal (Fig. 7) comprising a first output signal component at said first frequency, a second output signal component at said second frequency as well as a third output signal component at a third frequency, symmetrical to the second frequency in relation to the first frequency;
c2) measuring the relative level of the second output signal component and the relative level of the third output signal component, these relative levels being measured relative to the level of the first output signal component;
c3) calculating a variable indicative of dissimilarity between the spectrum of the bifrequency test signal and the output signal arising from the application of the bifrequency test signal to the electronic component (18, 28), on the basis of said measurements;
c4) predistorting the test signal by adjusting the predistortion setting parameters so as to minimize said dissimilarity;

the adjusted predistortion setting parameters being applied during said predistortion of at least part of the signal to be converted.

2. The method according to claim 1, wherein said variable indicative of dissimilarity is a variable indicative of the module of the AM/PM conversion coefficient of the electronic component (18, 28) and wherein said dissimilarity is minimized by minimization of the module of the AM/PM conversion coefficient.

3. The method according to claim 2, wherein the determination of predistortion setting parameters comprises

c5) applying a monofrequency test signal to the electronic component (18, 28),
c6) measuring the signal level obtained at the frequency of the monofrequency test signal at the output of the electronic component on application of the monofrequency test signal;
c7) calculating a variable indicative of the AM/AM distortion of the electronic component on the basis of said measurement;

the predistortion setting parameters being further adjusted so as to minimize AM/AM distortion.

4. The method according to claim 2, wherein determining predistortion setting parameters comprises calculating a variable indicative of the AM/AM distortion of the electronic component on the basis of the level measurement relating to the second output signal component and the level measurement relating to the third output signal component; and wherein the predistortion setting parameters are moreover adjusted so as to minimize AM/AM distortion.

5. The method according to any one of the claims 1 to 4, wherein said signal to be converted comprises a carrier modulated by a modulating signal and wherein predistortion of at least part of the signal to be converted comprises predistortion of the modulating signal.

6. The method according to any one of the claims 1 to 4, wherein said signal to be converted comprises a carrier modulated by a modulating signal and wherein the carrier modulated by the modulating signal is subjected to said predistortion.

7. The method according to any one of the claims 1 to 6, wherein steps c1) to c4) are carried out for a plurality of power levels of the bifrequency test signal.

8. The method according to claim 7 if dependent on claim 2, wherein the sign of the AM/PM conversion coefficient of the electronic component (18, 28) is determined for each power level of the bifrequency test signal.

9. The method according to claim 3 or any one of the claims 4 to 8 if dependent on claim 3, wherein steps c5) to c7) are carried out for a plurality of power levels of the monofrequency test signal.

10. The method according to the claims 8 and 9, wherein the adjustment of the predistortion setting parameters comprises calculating an AM/AM curve and an AM/PM curve of the electronic component (18, 28) and, optionally, calculating AM/AM and AM/PM curves which are respectively the inverse of the AM/AM and AM/PM curves of the electronic component (18, 28).

11. The method according to any one of the claims 1 to 10, wherein said electronic component is an amplifier, for example a power amplifier, and wherein said signal to be converted is a signal to be amplified.

12. A linearized electronic component (12), comprising:

an electronic component (18), intended to produce an output signal linearly dependent on a signal to be converted, said electronic component is preferably an amplifier, for example a power amplifier, and wherein said signal to be converted is a signal to be amplified;
a predistortion linearizer for predistorting (20) at least part of the signal to be converted upstream of the electronic component (18), the predistortion linearizer (20) being settable so as to at least in part compensate a nonlinear distortion of the electronic component; and
a calibration device (22) configured to determine predistortion setting parameters and to set the linearizer (20) accordingly;

the linearized electronic component (12) being **characterized in that** the calibration device (22) is configured to implement:

application of a bifrequency test signal (Fig. 6) to the electronic component (18), said test signal comprising a first input signal component at a first frequency and a second input signal component at a second frequency, the level of the second input signal component being at least 10 dB lower than the level of the first input signal component, so as to obtain, at the output of the electronic component (18), an output signal (Fig. 7) comprising a first output signal component at said first frequency, a second output signal component at said second frequency as well as a third output signal component at a third frequency, symmetrical to the second frequency in relation to the first frequency;
measurement of the level of the second output signal component and the level of the third output signal component;
calculation of a variable indicative of the module of the AM/PM conversion coefficient of the electronic component (18) on the basis of said measurements;
predistortion of the test signal by adjusting the predistortion setting parameters so as to minimize the module of the AM/PM conversion coefficient; and
setting of the linearizer (20) by applying predistortion setting parameters to the linearizer (20) for predistorting at least part of the signal to be converted.

13. The linearized electronic component (12) according to claim 12, wherein the calibration device (22) is configured to implement:

> application of a monofrequency test signal to the electronic component (18),
> measurement of the signal level obtained at the frequency of the monofrequency test signal at the output of the electronic component (18) on application of the monofrequency test signal;
> calculation of a variable indicative of the AM/AM distortion of the electronic component (18) on the basis of said measurement; and
> adjustment of the predistortion setting parameters so as to minimize AM/AM distortion.

14. An amplifier test bench (24), comprising
a location (26) for receiving an amplifier to be tested (28);
a predistortion linearizer (34) set up to predistort test signals to be applied to the amplifier (28) to be tested when the amplifier to be tested is placed in said location (26), the predistortion linearizer (34) being settable so as at least in part to compensate a nonlinear distortion of the amplifier (28); and
a calibration device (36) configured to determine predistortion setting parameters and to set the linearizer (34) accordingly and comprising an output (38) for outputting indicators of residual nonlinearity;
the calibration device (36) being configured to implement:
application of a bifrequency test signal (Fig. 6) to the amplifier to be tested (28), said test signal comprising a first input signal component at a first frequency and a second input signal component at a second frequency, the level of the second input signal component being at least 10 dB lower than the level of the first input signal component, so as to obtain, at the output of the amplifier to be tested (28), an output signal (Fig. 7) comprising a first output signal component at said first frequency, a second output signal component at said second frequency as well as a third output signal component at a third frequency, symmetrical to the second frequency in relation to the first frequency; measurement of the level of the second output signal component and the level of the third output signal component;
calculation of a variable indicative of the module of the AM/PM conversion coefficient of the amplifier to be tested (28) on the basis of said measurements;
predistortion of the test signal by adjusting the predistortion setting parameters so as to minimize the module of the AM/PM conversion coefficient; and
setting of the linearizer (34) by applying predistortion setting parameters to the linearizer (34) for predistorting the bifrequency test signal.

15. The test bench (24) according to claim 14, wherein the calibration device (36) is configured to implement:

> application of a monofrequency test signal to the amplifier to be tested (28),
> measurement of the signal level obtained at the frequency of the monofrequency test signal at the output of the amplifier to be tested (28) on application of the monofrequency test signal;
> calculation of a variable indicative of the AM/AM distortion of the amplifier to be tested (28) on the basis of said measurement; and
> adjustment of the predistortion setting parameters so as to minimize AM/AM distortion.

**Fig. 1**

Puissance de sortie
ou déphasage entrée-sortie

AM/AM

AM/PM

Puissance d'entrée

Puissance d'entrée à saturation

**Fig. 2**

AM/AM idéal mais
non réalisable

Puissance de sortie
ou déphasage entrée-sortie

AM/AM théorique

AM/AM

AM/PM théorique

Puissance d'entrée

Puissance d'entrée à saturation

**Fig. 3**

Fig. 4

Générateur
de signal

Signal modulant à transmettre

Modulateur

Signal de test

Pré-distorsion
du signal RF

Amplificateur

Boucle de calibration

Estimation des courbes
AM/AM et AM/PM

Mesures
spectrales

Fig. 5

**Fig. 6**

**Fig. 7**

Fig. 8

*34*

*32*

*28*

*26*

Générateur de signal numérique

Pré-distorsion du signal modulant

Modulateur

Amplificateur à tester

*30*

Signal de test

Estimation des courbes AM/AM et AM/PM

Boucle de calibration

Mesures spectrales

*38*

Courbes AM/AM et AM/PM résiduelles après linéarisation au mieux

*36*

*24*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2004040751 A1
- US 20070190952 A1
- US 20090058521 A1
- EP 2244380 A
- US 2006240786 A
- GB 2335812 A
- JP 2002135063 A

**Littérature non-brevet citée dans la description**

- **J. P. LAICO ; H. L. MCDOWELL ; C. R. MOSTER.** A Medium Power Traveling-Wave Tube for 6000-Mc Radio Relay. *Bell System Technical Journal,* Novembre 1956, vol. 3§ (6), 1285-1346
- **A. A. MOULTHROP ; C. J. CLARK ; C. F. SILVA ; M. S. MUHA.** A Dynamic AM/AM and AM/PM Measurement Technique. *IEEE MTT-S Digest,* 1997, 1455-1458